Europäisches Patentamt

European Patent Office

Office européen des brevets

(11) Veröffentlichungsnummer: **0 491 064 A1**

# EUROPÄISCHE PATENTANMELDUNG

(21) Anmeldenummer: **90124443.4**

(22) Anmeldetag: **17.12.90**

(51) Int. Cl.5: **H03K 23/68**, H03K 23/66

(43) Veröffentlichungstag der Anmeldung:
**24.06.92 Patentblatt 92/26**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Förg, Pirmin, Dr.-Ing.**
**Nockherweg 10**
**W-8018 Grafing(DE)**

(54) **Verfahren und Anordnung zum Teilen der Frequenz einer Wechselspannung mit einem nicht ganzzahligen Teilungsfaktor.**

(57) In einem synchronen Datennetz wie der Synchron-Digital-Hierarchie müssen in jedem Netzknoten Frequenzgeneratoren durch Synchronsignale beispielsweise einer Frequenz von 2,048 oder 1,544 MHz nachgesteuert werden, die von einem gemeinsamen Frequenznormal abgeleitet sind. Dafür fehlt ein auch anderweit einsetzbarer Teiler mit einem nicht ganzzahligem Teilungsfaktor und darüber hinaus die Möglichkeit, durch Positiv-Null-Negativ-Stopfen bedingte Frequenzfehler zu korrigieren. Ersteres ermöglicht eine Anordnung mit einem Teiler 23, der zwischen zwei Hilfs-Teilungsfaktoren (m, n) periodisch umgeschaltet wird. Letzteres läßt eine Anordnung zu, bei der Positiv (PST)- und Negativ (NST)-Stopfsignale teils unmittelbar, teils verzögert zu einem Decoder (1) und über diesen zu einem Akkumulator (9) gelangen. Von diesem erzeugte Adressen veranlassen ein Speicherpaar (15, 16) in Abhängigkeit von den Stopfsignalen bestimmte x- und y-Werte über einen Multiplexer (17) zu einem weiteren Akkumulator (21) zu geben, dessen Übertragssignal (U) den Teiler (23) zur Frequenzkorrektur steuert.

FIG 2

Die Erfindung bezieht sich auf ein Verfahren zum Teilen der Frequenz einer Wechselspannung mit einem nicht ganzzahligen Teilungsfaktor in eine zweite Frequenz unter alternierender Erzeugung einer ersten Periodengruppe mit einer ersten Periodenzahl durch Teilung mit einem ersten ganzzahligen Hilfs-Teilungsfaktor, dessen Wert über dem des Teilungsfaktors liegt, und einer zweiten Periodengruppe mit einer zweiten Periodenzahl durch Teilung mit einem zweiten ganzzahligen Hilfs-Teilungsfaktor, dessen Wert unter dem des Teilungsfaktors liegt.

Ein derartiges Verfahren ist von einem schaltbaren Teiler (Dual Modulus Divider) bekannt, der in dem "SP8000 Series High Speed Dividers Integrated Circuit Handbook", The Plessey Company plc, November 1981, Publication No. P.S. 1937, Seiten 140 bis 143 dargestellt ist.

In der Zeitschrift "IEEE Journal of Solid-State Circuits", April 1989, Volume 24, Number 2, Seiten 204 bis 266 ist eine Sigma-Delta-Modulation beschrieben. Bei dieser Modulationsart werden Amplitudenwerte im Takt integriert. Beim Erreichen eines Schwellenwertes wird ein Impuls abgegeben und der Integrator zurückgestellt. Die Impulsfolgefrequenz hängt von der Größe des einzelnen Amplitudenwerts ab.

In der Zeitschrift "ntz", 41 (1988) Heft 10, Seiten 57 bis 574 wird eine Synchron-Digital-Hierarchie SDH mit einer Basis-Bitrate von 155,52 Mbit/s beschrieben, in der Signale sowohl aus der europäischen als auch der nordamerikanischen Plesiochron-Digital-Hierarchie PDH in synchrone Transportmodule genannten Pulsrahmen übertragen werden.

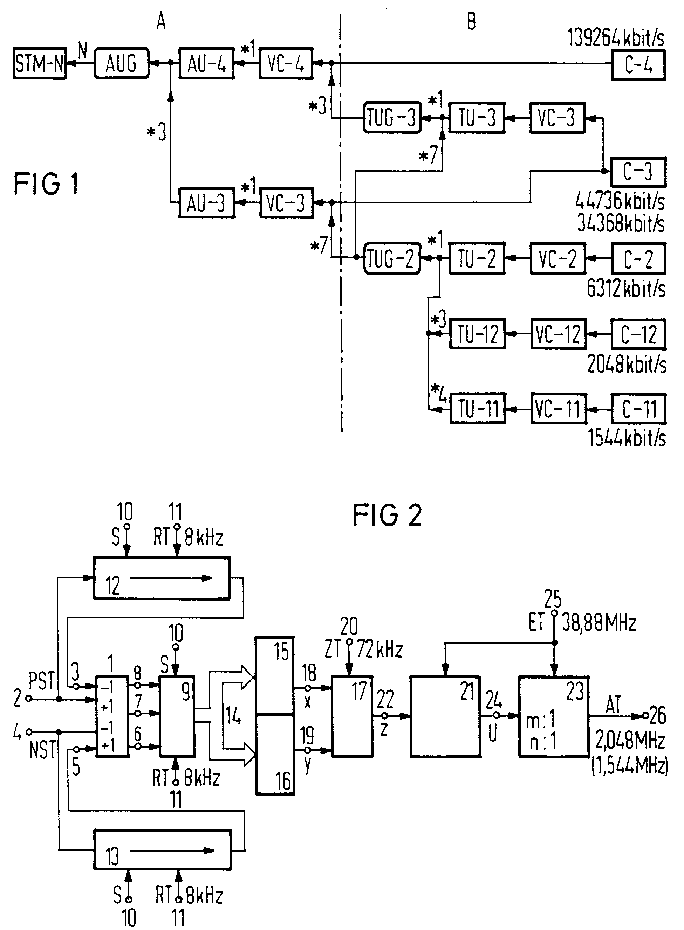

Figur 1 zeigt eine Multiplexstruktur der Synchron-Digital-Hierarchie SDH. Es bedeutet AU Verwaltungseinheit (Administrative Unit), AUG Verwaltungseinheitengruppe (Administrative Unit Group), C Container, STM Synchrones Transportmodul, TU Untersystemeinheit (Tributary Unit), TUG Untersystemeinheitengruppe (Tributary Unit Group) und VC Virtualcontainer. Die angehängten Ziffern oder Ziffernpaare n bezeichnen die Lage in der Multiplexstruktur. A ist ein Bereich höherer Ordnung, B ein Bereich niederer Ordnung.

Zu übertragende plesiochrone Digitalsignale werden beim Multiplexen periodisch mit Hilfe von positivem Stopfen in Container C-n eingefügt. Jeder von diesen wird durch Hinzufügen eines Pfadrahmenkopfes (Path Overhead) zu einem Virtualcontainer VC-n ergänzt. Die zeitliche Lage dessen ersten Bytes im Rahmen eines STM-N-Signals (N = 1, 2, 4, 8, 12, 16) oder eines Virtualcontainers einer höheren Hierarchiestufe wird durch einen Zeiger (Pointer) angegeben. Ein Virtualcontainer VC-11, VC-12, VC-2 oder VC-3 kann mit dem ihm zugeordneten Zeiger eine Untersystemeinheit TU-n bilden. Mehrere dieser gleichen Aufbaus können weiter zu einer Untersystemeinheitengruppe TUG-n zusammengefaßt werden, die wiederum in einem Virtualcontainer VC-3 oder VC-4 Platz findet. Dieser wird in eine Verwaltungseinheit AU-3 oder AU-4 eingefügt, die zusammen mit einem Verwaltungseinheitszeiger zu einer Verwaltungseinheitengruppe AUG zusammengefaßt werden kann. Diese bildet mit dem Abschnittskopf (Section Overhead) ein STM-1-Signal. Mehrere dieser bilden ein STM-N-Signal. Beim Demultiplexen verlaufen die Verfahrensschritte umgekehrt. Die Ziffern an den Leitungen geben an, wievielmal die Rahmenteile zusammen übertragen werden.

In einem synchron arbeitenden Netz sollten keine frequenzausgleichenden Stopfvorgänge erforderlich sein. Da jedoch bei längeren Kabelstrecken aufgrund von Kabel-Laufzeitschwankungen größere Phasenverschiebungen zu vermeiden sind, und da außerdem Frequenzabweichungen bei Synchronisationsausfällen sowie bei Übergängen zu anderen Netzen ausgeglichen werden müsssen, kommt den Zeigern eine weitere Aufgabe zu.

Mit dem Zeiger wird nicht nur eine Phasendifferenz zwischen Virtualcontainer und STM-Rahmen berücksichtigt, sondern es lassen sich bei Bedarf auch Frequenzunterschiede zwischen einem STM-N-Eingangs- und Ausgangssignal bzw. Netzknotentakt durch ein Positiv-Null-Negativ-Stopfverfahren ausgleichen. Dazu besteht der Zeiger aus einem H1-, einem H2- und einem H3- Byte. Die beiden ersten enthalten den eigentlichen Zeiger, der die Lage des ersten Bytes des Virtualcontainers bezeichnet und eine Stopfinformation enthält, und das H3-Byte kann bei Frequenzausgleichsvorgängen ein Informationsbyte sein.

Im Falle eines Frequenzversatzes zwischen dem STM-Rahmentakt und dem Rahmentakt des Virtualcontainers muß der Zeiger gelegentlich verändert werden, wobei zum Frequenzausgleich je nach Lage in der Multiplexstruktur dann entweder ein positives oder negatives Stopfbyte oder auch deren drei im STM-Rahmen vorgesehen wird.

Ist der Rahmentakt des Virtualcontainers gegenüber dem STM-Rahmentakt zu langsam, so muß der Anfang des Virtualcontainers in zeitlichen Abständen innerhalb des Rahmens auf einen späteren Zeitpunkt versetzt werden. Bei einem solchen Ausgleichsvorgang wird ein bzw. werden drei Leerbytes in den Nutzinformationsblock im Anschluß an den Abschnittskopf eingesetzt und der Zeiger wird um eine Wertstufe inkrementiert (Positivstopfen), wobei diese einen Sprung über drei Bytes beinhaltet.

Ist der Rahmentakt des Virtualcontainers gegenüber dem STM-N Rahmentakt zu schnell, so muß der Anfang des Virtualcontainers innerhalb des STM-Rahmens auf einen früheren Zeitpunkt versetzt werden.

2

EP 0 491 064 A1

Bei einem solchen Ausgleichsvorgang wird der Zeigerwert um eine Wertstufe dekrementiert, und es muß ein bzw. müssen drei zusätzliche Informationsbytes übertragen werden (Negativstopfen). Dieses wird in das eine bzw. die drei H3-Bytes des Zeigers, das Zeigeraktionsbyte, eingefügt.

Neben dem eigentlichen Zeigerwert enthalten die beiden ersten Zeigerbytes die Information, ob positiv, null oder negativ gestopft wurde.

Bei einer Kreuzschaltungseinrichtung (Cross Connect), in der Virtualcontainer der Arten VC-11, VC-12, VC-2 oder VC-3 (im Bereich niederer Ordnung B) durchgeschaltet und ausgangsseitig zu STM-N-Signalen zusammengesetzt werden, muß einmal bei diesem und einmal bei einem Virtualcontainer wie VC-3 (im Bereich höherer Ordnung A) oder VC-4, in dem der durchgeschaltete Virtualcontainer Aufnahme gefunden hat, positiv-null-negativ gestopft werden.

In einem Netzwerk der Synchron-Digital-Hierarchie SDH muß jedem Netzknoten ein Synchrontakt zur Verfügung stehen, der zu dem Netzknoten synchron ist, dem das Frequenznormal zugeordnet ist.

Der Synchrontakt könnte über ein eigenes Leitungsnetz verteilt werden. Er könnte aber auch aus der Taktfrequenz der vom Netzknoten mit dem Frequenznormal stammenden synchronen Transportmodule abgeleitet werden. Dies ist jedoch dann nicht exakt möglich, wenn ein Netzknoten in der Zuführungsstrecke im Haltemodus (Hold Over Mode) verharrt und seinen Takt selbst erzeugt. Ein älterer Vorschlag (P 4033557.7) geht deswegen dahin, als Synchronisiersignal den Takt eines Virtualcontainers zu verwenden, der in einem STM-N-Signal enthalten ist, das von dem Netzknoten mit Frequenznormal her ankommt. Die Taktfrequenz ist aus der des Frequenznormals abgeleitet und weist die gleiche Frequenzstabilität wie dieses auf.

Aufgabe der Erfindung ist es, ein Verfahren und eine Anordnung zur Teilung der Frequenz einer Wechselspannung mit nicht ganzzahligem Teilungsfaktor anzugeben. Insbesondere soll aus dem Takt eines STM-1-Signals einer Frequenz von 155,52 MHz eine Frequenz von 2,048 oder 1,544 MHz gewonnen werden.

Diese Aufgabe wird erfindungsgemäß mit den Merkmalen des Anspruchs 1 gelöst. Ausgestaltungen des Verfahrens und Anordnungen zur Durchführung des Verfahrens sind den Unteransprüchen zu entnehmen.

Um die Schaltung in CMOS-Technik realisieren zu können, wird nicht von der Frequenz 155,52 MHz des STM-1-Signals, sondern von einem Viertel dieser Frequenz, nämlich 38,88 MHz ausgegangen. Diese Frequenz ergibt einen um einen Faktor zwei geringeren Jitter als wenn man von der Bytetaktfrequenz 19,44 MHz ausgehen würde.

Anhand von Ausführungsbeispielen wird die Erfindung nachstehend näher erläutert:

Fig. 1  zeigt - wie bereits erläutert - eine Multiplexstruktur der Synchron-Digital Hierarchie,
Fig. 2  zeigt ein Prinzipschaltbild der Erfindung für Positiv-Null-Negativ-Stopfen in einem Bereich,
Fig.3a  zeigt den Decoder in Figur 2 detailliert,
Fig.3b  zeigt eine Wertetabelle zum Decoder,
Fig.4a  zeigt den ersten Akkumulator in Figur 2 detailliert,
Fig.4b  zeigt ein Rechenschema zum ersten Akkumulator,
Fig. 5  zeigt den zweiten Akkumulator in Figur 2 detailliert,
Fig. 6  zeigt den Teiler in Figur 2 detailliert und
Fig. 7  zeigt ein Prinzipschaltbild der Erfindung für Positiv-Null-Negativ-Stopfen sowohl im Bereich A als auch im Bereich B in der Multiplexstruktur nach Figur 1.

Figur 2 zeigt das Prinzipschaltbild der erfindungsgemäßen Anordnung für Positiv-Null-Negativ-Stopfen im Bereich A. Die Anordnung enthält einen Decoder 1, Akkumulatoren 9 und 21, Schieberegister 12 und 13, Schreib-Lese-Speicher (RAM) 15 und 16, einen Multiplexer 17 und einen schaltbaren Teiler 23.

Dem schaltbaren Teiler 23 (18/19:1 für 2,048 MHz und 25/26:1 MHz für 1,544 MHz) wird über einen Eingang 25 ein Eingangstakt ET einer Frequenz von 38,88 MHz zugeführt und ein Ausgangstakt einer Frequenz 2,048 MHz bzw. 1,544 MHz über einen Ausgang 26 entnommen. Zur Korrektur der Frequenz des Ausgangstaktes AT dienen Stopfsignale PST für Positiv-Stopfen und NST für Negativ-Stopfen eines STM-1-Signals. Es handelt sich dabei um den Verwaltungseinheitszeiger AU-4 PTR oder AU-3 PTR. Die Stopfsignale PST werden auf den Eingang 2 und über das Schieberegister 12 auf den Eingang 3, die Stopfsignale NST auf den Eingang 4 und über das Schieberegister 13 auf den Eingang 5 des Decoders 1 gegeben.

Beide Schieberegister 12 und 13 haben eine Länge 4L. Dieser Faktor gibt die Anzahl der STM-1-Rahmen an, über die die aufgrund der Zeigeraktion notwendige Phasenänderung verteilt wird. Der Faktor 4 resultiert dabei aus der Forderung, daß nur alle vier Rahmen eine Zeigeraktion auftreten darf. Liegen keine Zeigeraktivitäten vor, sind die Schieberegister 12 und 13 leer. Logische Zustände "1" an den Eingängen 3 und/oder 4 erfordern jeweils eine Subtraktion von eins oder zwei und logische Zustände "1" an den Eingängen 2 und/oder 4 erfordern jeweils eine Addition von eins oder zwei. Der Decoder 1 bietet neben einem Wert null über seine Ausgänge 6 und 7 positive Werte eins und zwei oder negative Werte eins und

3

zwei im Zweierkomplement und über seinen Ausgang 8 das Vorzeichen VZ an. Der Akkumulator 9 setzt diese Werte in sieben Adressen um, die über den Bus 14 an die Speicher 15 und 16 gelangen und dort nach Anspruch 3 festgelegte Paare aus einem x- und einem y-Wert auslesen. Diese werden im Multiplexer 17 vom Zeilentakt ZT gesteuert derart verschachtelt, daß das Ausgangssignal Z aus 269 x-Werten und einem y-Wert besteht. Dieses wird vom Eingangtakt ET gesteuert im Akkumulator 21 addiert. Übertragssignale U steuern die Umschaltung der Hilfs-Teilungsfaktoren m und n im Teiler 23.

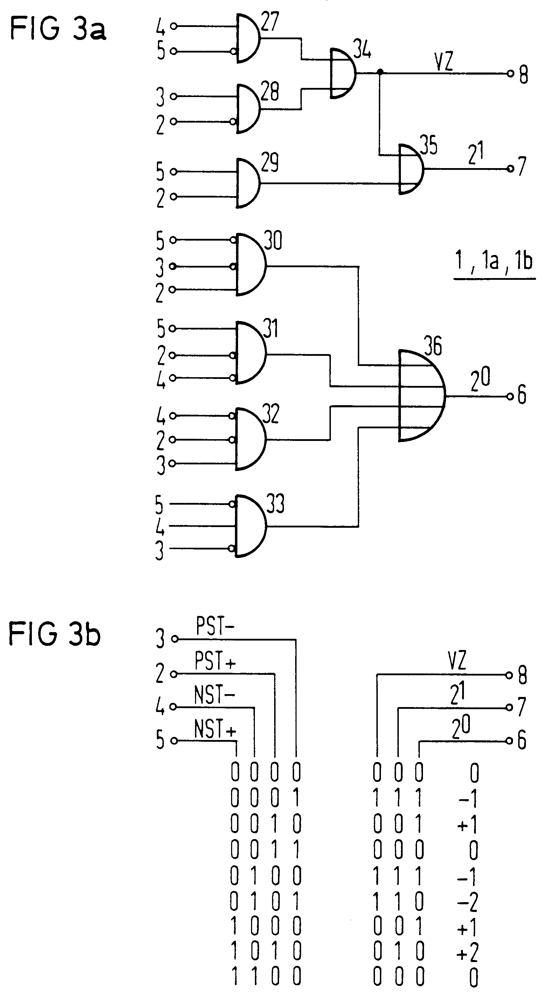

Figur 3a zeigt den aus einer Gatterschaltung bestehenden Decoder 1 mit UND-Gattern 27-33 mit teils invertierenden Eingängen und mit ODER-Gattern 34-36. Figur 3b zeigt die decodierten Werte für alle möglichen Fälle binär und dezimal.

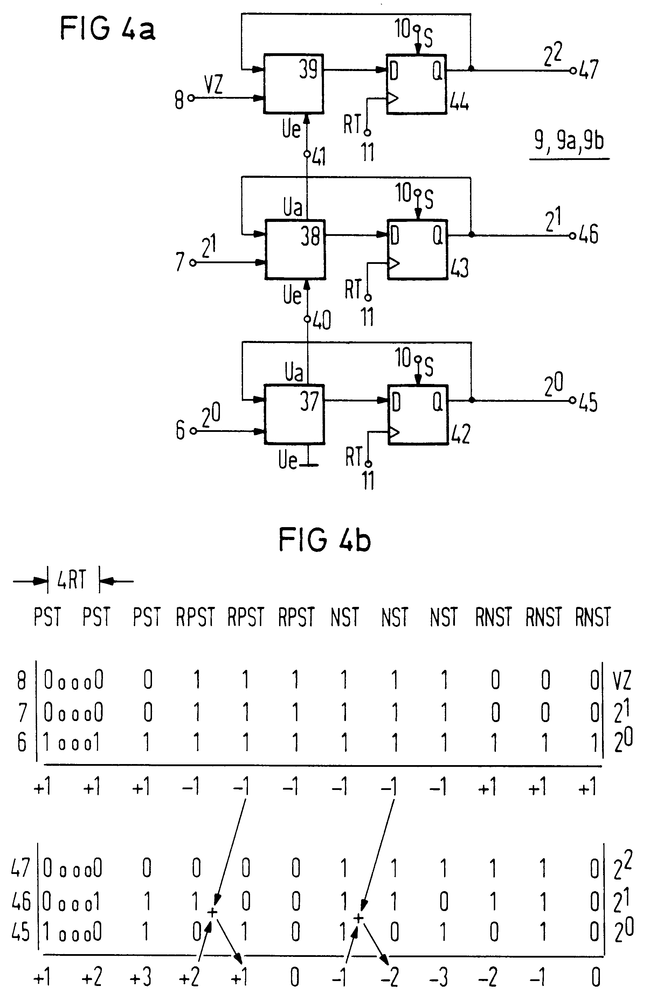

Figur 4a zeigt den Akkumulator 9 nach Figur 2. Er arbeitet als +/- 1 - bzw. +/- 2 - Zähler. Beachtet man die Polarität, dann ergeben sich sechs Zählerstände und der Wert Null, also insgesamt sieben Adressen für die Festspeicher 15 und 16.

Die Anordnung besteht aus drei Akkumulatorelementen, die jeweils aus einem 2-bit-Volladdierer 37, 38 oder 39 und einem D-Flipflop 42, 43 oder 44 bestehen.

Im folgenden werden logische Zustände kurz mit "1" und "0" bezeichnet.

Durch einen Setzimpuls S am Setzeingang 10 werden anfangs alle Ausgänge 45 bis 47 auf "0" gebracht. Erhält jetzt der Eingang 6 den Zustand "1", dann addiert der 2-bit-Volladdierer 37 zur "0" am Ausgang 45 die "1" am Eingang 6. Da der Übertragseingang Ue auch auf "0" liegt, erscheint am Ausgang des 2-bit-Volladdierers 37 eine "1", die mit dem nächsten Rahmentakt RT am Takteingang 11 an den Q-Ausgang des D-Flipflops 42 weitergegeben wird. Da an den Eingängen 7 und 8 und den jeweiligen Übertragssignaleingängen Ue keine "1" anliegt, bleiben die Ausgänge 46 und 47 auf "0". Beim nächsten Rahmentakt RT erscheint eine "0" am Eingang 6. Da aber am Ausgang 45 noch eine "1" anliegt, gibt der 2-bit-Volladdierer 37 erneut eine "1" an das D-Flip-flop 42 ab. Diese wird beim nächsten Rahmentakt RT an den Ausgang 45 weitergegeben.

Wird jetzt erneut gestopft, dann kommt wieder eine "1" an den Eingang 6 und der 2-bit-Volladdierer 37 muß zweimal "1" addieren. Die Folge ist, daß an seinem Ausgang eine "0" und am Übertragssignalausgang Ua eine "1" erscheint, die über die Übertragssignalleitung 40 weitergegeben wird. Beim 2-bit-Volladdierer 38 liegt jetzt an beiden Eingängen eine "0" und am Übertragssignaleingang Ue die "1". Am Ausgang des 2-bit-Volladdierers 38 tritt eine "1" auf, die beim nächsten Rahmentakt RT an den Ausgang 46 weitergegeben wird.

Bei positivem Stopfen PST am Eingang 2 des Decoders 1 kann der Fall eintreten, daß die Korrektur für ein zeitlich zurückliegendes negatives Stopfen NST über das Schieberegister 13 zur gleichen Zeit eintrifft. Das gleiche gilt bei negativem Stopfen NST und Korrektur eines zeitlich zurückliegenden positiven Stopfens PST über das Schieberegister 12. Der Akkumulator 9 muß dann jeweils zwei Schritte zählen.

Figur 4b zeigt ein Zählbeispiel für den Akkumulator 9 nach Figur 4a. In der oberen Hälfte werden die logischen Zustände an den Decoderausgängen 6 bis 8 für ein positives Stopfsignal PST, für die Reaktion RPST auf das positive Stopfsignal PST über das Schieberegister 12, für ein negatives Stopfsignal NST und für die Reaktion RNST auf das negative Stopfsignal NST über das Schieberegister 13 gezeigt. Darunter sind die Zahlenwerte für jedes vierte dreistellige Codewort aufgetragen. In der unteren Hälfte sind die logischen Zustände an den Ausgängen 45 bis 47 gezeigt. Jeweils drei Pfeile demonstrieren die Addition. Bei der linken Pfeilgruppe wird -1 am Eingang des Akkumulators 9 mit +2 am Ausgang des Akkumulators 9 addiert und es erscheint das Ergebnis +1. Bei der rechten Pfeilgruppe wird -1 mit -1 addiert und es ergibt sich -2.

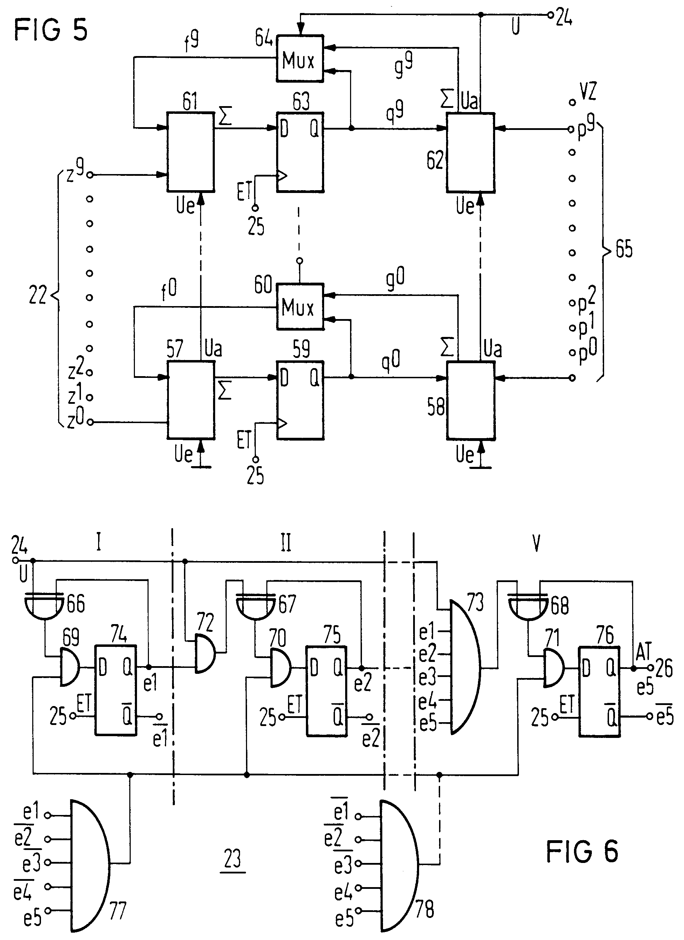

Figur 5 zeigt den Akkumulator 21 nach Figur 2. Er enthält zehn Akkumulatorelemente, von denen das erste 2-bit-Volladdierer 57 und 58, ein D-Flipflop 59 und einen Multiplexer 60 und das zweite, zwei 2-bit-Volladdierer 61 und 62, ein D-Flipflop 63 und einen Multiplexer 64 enthält. Die Akkumulatorelemente sind hier aufwendiger als die in Figur 4a, da die Akkumulatortiefe 576 und damit keine Zweierpotenz ist. Die Akkumulatortiefe muß hier immer ein Vielfaches von drei sein, da Phasensprünge von 3 * 8 bit ausgeglichen werden müssen. Der Wert 576 wurde mit $9 * 2^6$ gewählt.

Die Zahl q an den linken Eingängen der zehn 2-bit-Volladdierer 58, 62 wird mit der Zahl p = 576 im Zweierkomplement, die am Eingang 65 fest anliegt, verglichen. Das Übertragssignal U am Anschluß 24 gibt an, ob die Zahl q größer oder kleiner als die Zahl p ist.

Ist $q \geqq p$, dann ist U = logisch "1". Ist dagegen $q < p$, dann ist U = logisch "0", und der Akkumulator 21 hat den Wert 576 noch nicht erreicht. Ist U = "0", dann legen die zehn Multiplexer 60, 64 die Zahl q als Zahl f an die oberen Eingänge der zehn 2-bit-Volladdierer 57, 61. Ist dagegen U = "1", dann lassen die zehn Multiplexer 60, 64 die Zahl g = q - p als Zahl f zu den oberen Eingängen der zehn 2-bit-Volladdierer 57, 61 durch. Wird jetzt an die Eingänge 22 eine Zahl z angelegt, dann wirkt der Teilakkumulator mit den zehn 2-bit-Volladdierern 57, 61 und den zehn D-Flipflops 59, 63 so wie der Akkumulator 9 nach Figur 4a.

Das Übertragssignal U wird über den Anschluß 24 an den Teiler 23 weitergegeben.

Die Figur 6 zeigt den Teiler 23 nach Figur 2. Die Anordnung enthält Exklusiv-ODER-Gatter 66 bis 68, UND-Gatter 69 bis 73, D-Flipflops 74 bis 76 und NAND-Gatter 77 oder 78. Das NAND-Gatter 77 wird für einen Ausgangtakt AT von 2,048 MHz und das NAND-Gatter 78 für ein Ausgangstakt AT von 1,544 MHz benötigt. Die Anordnung enhält somit entweder das NAND-Gatter 77 oder das NAND-Gatter 78.

Im folgenden wird ein Ausführungsbeispiel mit dem NAND-Gatter 77 beschrieben:

Jede Stufe I bis V ist eine synchrone 1-bit-Teilerschaltung. Ein Ausgangssignal "0" des NAND-Gatters 77 bewirkt, daß mit dem Eingangstakt ET e1-e5 den Zustand "0" annehmen. Jetzt soll das Ausgangssignal des NAND-Gatters 77 "1" sein. Ein Zustand "0" am Anschluß 24 wirkt für die Teilerstufen I bis V als Freigabesignal (enable). Tritt am Eingang 24 ein Übertragsimpuls U auf, dann nimmt der Ausgang des Exklusiv-ODER-Gatters 66 und des UND-Gatters 69 den Zustand "1" an. Mit dem nächsten Eingangstakt ET wird el zu "1". Damit liegt an beiden Eingängen des Exklusiv-ODER-Gatters 66 eine "1" an. Dann nimmt dessen Ausgang und der Ausgang des UND-Gatters 69 und damit der D-Eingang des D-Flipflops 74 den Zustand 0" an. Mit dem Eingangtakt ET wird dieser Zustand an e1 weitergegeben. Ein Zustand "0" am Anschluß 24 verhindert ein weiteres Kippen. Alle nachfolgenden Stufen können nur kippen, wenn jeweils die Q-Ausgänge aller D-Flipflops der vorangegangenen Stufen und der Übertragsimpuls U logisch "1" sind. Dies bewirken die UND-Gatter 72 und 73. Der Teiler 23 arbeitet als synchroner Zähler.

Beim Teiler 18/19:1 muß bei 17 zurückgesetzt werden und beim Teiler 25/26:1 bei 24. Dabei wird berücksichtigt, daß auch Null eine Zahl ist. Die Zahl 17 wird mit dem NAND-Gatter 77 ermittelt. e1 = "1" und e5 = "1" ergeben 17, wenn e2, e3 und e4 = "0". Die Zahl 24 wird mit dem NAND-Gatter 78 ermittelt. e4 = "1" und e5 = "1" sind 24, wenn e1, e2 und e3 = "0".

Wenn die Zahl 17 bzw. 24 erreicht ist, geht der logische Zustand am Ausgang der NAND-Gatter 77 bzw. 78 auf "0" und der Teiler 23 wird zurückgesetzt. Damit teilt er jetzt durch 18 bzw. 25. Geht der Übertragsimpuls U, der vom Akkumulator 21 kommt, auf "0", dann bleibt der Teiler 23 für genau einen Takt stehen. Weil der Akkumulator 21 und der Teiler 23 mit dem gleichen Eingangtakt ET gesteuert werden, geht der Übertragsimpuls U beim nächsten Eingangtakt ET auf "1" und der Zähler 23 wird wieder aktiviert.

Das Anhalten des Teilers 23 für einen Takt bedeutet ein Teilen des Eingangtakts ET durch 19 bzw. durch 26.

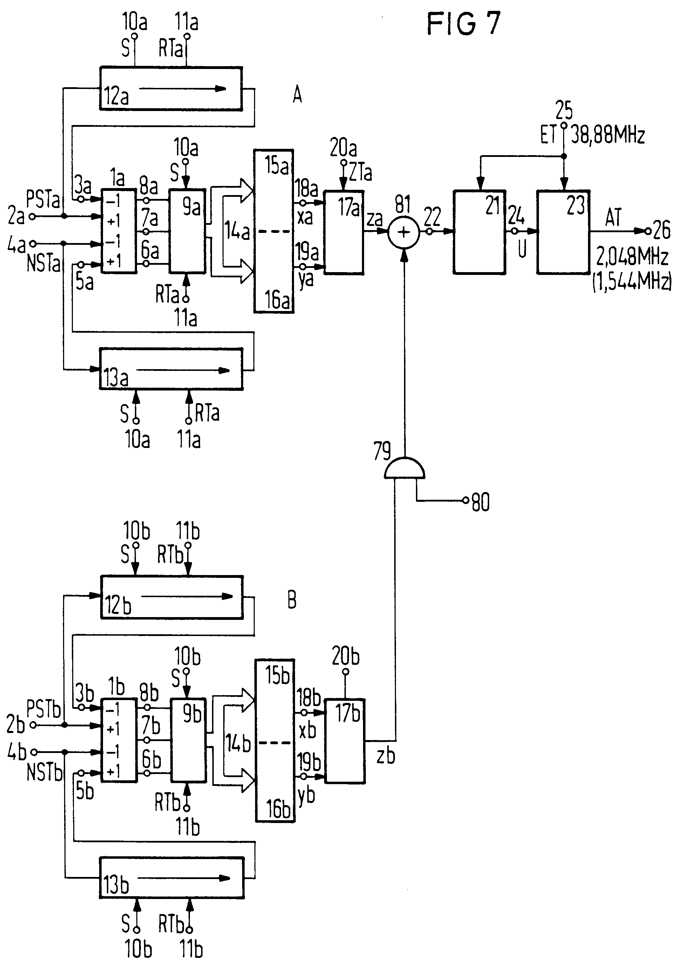

Figur 7 zeigt eine erfindungsgemäße Anordnung, die Stopfsignale PSTa und NSTa aus dem oberen Bereich A und Stopfsignale PSTb und NSTb aus dem unteren Bereich B der Multiplexstruktur nach Figur 1 verarbeitet. Die Elemente 1a bis 20a und 1b bis 20b sind schaltungstechnisch gleich. Allerdings wird im Bereich A ein Rahmentakt RTa des STM-1-Signals und dessen Zeilentakt ZTa angelegt, während im Bereich B ein Rahmentakt RTb eines Virtualcontainers VC-4 bzw. VC-3 und ein Zeilentakt ZTb dieser Virtualcontainer angelegt. Die in den Festspeichern 15a und 16a bzw. 15b und 16b gespeicherte Werte, sind verschieden. Die Ausgangssignale der Multiplexer 17a und 17b za und zb werden in einem Addierer 81 addiert und dem aus Figur 2 bekannten Akkumulator 21 und Teiler 23 zugeführt. Die Zuführung des Ausgangssignals zb kann durch das UND-Gatter 79 unterbrochen werden, wenn an dessen Eingang 80 ein Signal angelegt wird, daß die Anwesenheit des Virtualcontainers VC-4 bzw. VC-3 unter Berücksichtigung der Stopfbytes anzeigt.

**Patentansprüche**

**1.** Verfahren zum Teilen der Frequenz $f_1$ einer Wechselspannung mit einem nicht ganzzahligen Teilungsfaktor in eine zweite Frequenz $f_2$ unter alternierender Erzeugung einer ersten Periodengruppe mit einer Periodenzahl a durch Teilung mit einem ersten ganzzahligen Hilfs-Teilungsfaktor m, dessen Wert über dem des Teilungsfaktors liegt, und einer zweiten Periodengruppe mit einer Periodenzahl b durch Teilung mit einem zweiten ganzzahligen Hilfs-Teilungsfaktor n, dessen Wert unter dem des Teilungsfaktors liegt,
**dadurch gekennzeichnet,**
daß v Perioden der Wechselspannung der Frequenz $f_1$ einem Rahmen zugeordnet werden,
daß am + bn = v und $(a + b)/f_2 = v/f_1$ gewählt wird und daß die Umschaltung zwischen den Periodengruppen durch ein Signal eines festen Werts z bewirkt wird, das sigma-delta-moduliert ist.

**2.** Verfahren nach Anspruch 1,
**dadurch gekennzeichnet,**
daß der Wert z mit jedem Taktimpuls der Frequenz $f_1$ bis zu einem Überlaufwert akkumuliert wird, bei dessen Erreichen und vor einem Neubeginn der Akkumulation ein Übertragsimpuls (U) abgegeben wird.

**3.** Verfahren nach Anspruch 1 oder 2 mit der Frequenz $f_1 = f_0/4 = 38{,}88$ MHz aus der Taktfrequenz $f_0$ eines STM-1-Signals mit einem 125 $\mu$s andauernden Rahmen aus 9 * 270 Oktetts und mit Positiv-Null-Negativ-Stopfen,
**dadurch gekennzeichnet,**
daß der Wert z durch Werte x während c Oktetts und Werte y während d Oktetts bei c + d = 270 für Zeigeraktionen im Bereich höherer Ordnung (A) und c + d = 261 für Zeigeraktionen im Bereich niederer Ordnung (B) angenähert wird und daß sich verschiedene Werte von x und y aus den Beziehungen für Positiv-Stopfen

$$\frac{2 * 9 \ (c * x_1 + d * y_1)}{TA} = C1 - C2$$

für Null-Stopfen

$$\frac{2 * 9 \ (c * x_2 + d * y_2)}{TA} = C1$$

und für Negativ-Stopfen

$$\frac{2 * 9 \ (c * x_3 + d * y_3)}{TA} = C1 + C2$$

ergeben, wobei

| | |
|---|---|
| TA | die Anzahl von Takten der Frequenz $f_1$ zum Erzeugen eines Übertragsimpulses ist, |
| C1 | die Anzahl der erforderlichen Übertragungsimpulse (U) ist und |
| C2 = C/4L | die Anzahl der erforderlichen zusätzlichen bzw. auszulassenden Übertragungsimpulse (U) ist, die einen Phasensprung abbauen, wobei |
| C = 6 | bei Sprüngen der Zeiger AU-4 PTR, AU-3 PTR und TU-3 PTR, |
| C = 42 | bei einem Sprung des Zeigers TU-2 PTR, |
| C = 126 | bei einem Sprung des Zeigers TU-12 PTR, |
| C = 168 | bei einem Sprung des Zeigers TU-11 PTR und |
| L = 1, 2, 3, ... | für die Anzahl von aus vier Rahmen bestehenden Überrahmen, über die die Phasenänderung verteilt wird. |

**4.** Verfahren nach Anspruch 3 zum Teilen der Frequenz $f_1 = 38{,}88$ MHz in eine Frequenz $f_2 = 2{,}048$ MHz,
**dadurch gekennzeichnet,**
daß z = 4860, m = 19, n = 18, a = 252, b = 4, c = 269, d = 1, TA = 576, C1 = 252, C2 = 0,5, $x_1$ = 29, $y_1$ = 247, $x_2$ = 29, $y_2$ = 263, $x_3$ = 30 und $y_3$ = 10 gewählt wird.

**5.** Verfahren nach Anspruch 3 zum Teilen der Frequenz $f_1 = 38{,}88$ MHz in eine Frequenz $f_2 = 1{,}544$ MHz,
**dadurch gekennzeichnet,**
daß z = 4860, m = 26, n = 25, a = 35, b = 158, c = 269, d = 1, TA = 576, C1 = 35, C2 = 0,5, $x_1$ = 4, $y_1$ = 28, $x_2$ = 4, $y_2$ = 44, $x_3$ = 4 und $y_3$ = 60 gewählt wird.

**6.** Verfahren nach Anspruch 3,
**dadurch gekennzeichnet,**
daß TA $= 3 * 2^o$ gewählt wird, wobei o eine ganze Zahl ist.

**7.** Verfahren nach Anspruch 3,
**dadurch gekennzeichnet,**

daß bei Sprüngen der Zeiger AU-4 PTR oder AU-3 PTR einerseits und/oder der Zeiger TU-3 PTR, TU-2 PTR, TU-12 PTR oder TU-11 PTR andererseits jeweils verschiedene Werte x und y gewählt werden.

8. Anordnung zur Durchführung des Verfahrens nach einem der Ansprüche 1 bis 7 mit einem über einen Steuereingang (24) zwischen zwei Hilfs-Teilungsfaktoren m und n umschaltbaren Teiler (23),
**dadurch gekennzeichnet,**
daß ein Sigma-Delta-Modulator vorgesehen ist, dessen Ausgang mit dem Steuereingang (24) des Teilers (23) verbunden ist.

9. Anordnung nach Anspruch 8,
**dadurch gekennzeichnet,**
daß als Sigma-Delta-Modulator ein erster Akkumulator (21) vorgesehen ist, der von der Frequenz $f_1$ getaktet mit jeder Taktperiode einen Wert z zu einem bereits erreichten Wert hinzugefügt, beim Überlauf einen Übertragsimpuls (U) abgibt und sich zurücksetzt.

10. Anordnung nach Anspruch 9,
**dadurch gekennzeichnet,**
daß die Werte $x_1$, $x_2$, $x_3$ in Zellen eines ersten Speichers (15, 15a, 15b) und die Werte $y_1$, $y_2$, $y_3$ in Zellen eines zweiten Speichers (16, 16a, 16b) eingeschrieben sind und daß ein vom Zeilentakt (ZT) einer Frequenz 72 kHz gesteuerter Multiplexer (17) vorgesehen ist, dessen erster Eingang für 269 Oktetts mit dem Ausgang des ersten Speichers (15, 15a), dessen zweiter
Eingang für ein Oktett mit dem Ausgang des zweiten Speichers (16, 16a) und dessen Ausgang mit dem Steuereingang (22) des Akkumulators (21) verbunden ist.

11. Anordnung nach Anspruch 10,
**dadurch gekennzeichnet,**
daß ein vom Rahmentakt (RT, RTa) einer Frequenz 8 kHz gesteuerter zweiter Akkumulator (9) mit vorgeschaltetem Decoder (1) vorgesehen ist, der bei einem Positivstopfsignal (PST) an einem ersten Eingang (2, 2a) einen Schritt vorwärts und bei einem Negativstopfsignal (NST) an einem zweiten Eingang (4, 4a) einen Schritt zurück zählt,
daß ein erstes vom Rahmentakt (RT, RTa) gesteuertes Schieberegister (12) mit 4L Stufen vorgesehen ist, über das bei einem Positivstopfsignal (PST) an einem dritten Eingang (3, 3a) der zweite Akkumulator (9) verzögert einen Schritt zurück zählt, und
daß ein zweites vom Rahmentakt (RT, RTa) gesteuertes Schieberegister (13) mit 4L Stufen vorgesehen ist, über das bei einem Negativstopfsignal (NST) an einem vierten Eingang (5, 5a) der zweite Akkumulator (9) verzögert einen Schritt vorwärts zählt, wobei L die Anzahl der Vierfach-Überrahmen angibt, in deren letztem eine Zeigeraktion auftreten darf.

12. Anordnung nach Anspruch 10 und 11 zur Durchführung des Verfahrens nach Anspruch 7,
**dadurch gekennzeichnet,**
daß der Decoder (1b), die Schieberegister (12b, 13b), der zweite Akkumulator (9b), der Bus (14b), die Speicher (15b, 16b) und der Multiplexer (17b) ein zweites Mal vorgesehen sind,
daß diese Schieberegister (12b, 13b) und dieser zweite Akkumulator (9b) von einem zweiten Rahmentakt (RTb) und dieser Multiplexer (17b) von einem zweiten Zeilentakt (ZTb) gesteuert werden,
daß die Ausgänge beider Multiplexer (17a, 17b) über einen Addierer (81) mit dem Eingang des ersten Akkumulators (21) verbunden sind und
daß ein UND-Gatter (79) vorgesehen ist, dessen erster Eingang mit dem Ausgang des zweiten Multiplexers (17b), dessen zweiter Eingang (80) dem Empfang eines Virtualcontainer- und Stopfbyte-Anwesenheitssignals dient und dessen Ausgang mit dem zugehörigen Eingang des Addierers (81) verbunden ist.

# FIG 1

STM-N —N→ AUG —•— AU-4 ←*1— VC-4

139264 kbit/s

C-4

*3

*3

TUG-3 ←*1— TU-3 ←— VC-3

*7

C-3

44736 kbit/s
34368 kbit/s

AU-3 ←*1— VC-3

*7

TUG-2 ←*1— TU-2 ←— VC-2 ←— C-2

6312 kbit/s

*3

TU-12 ←— VC-12 ←— C-12

2048 kbit/s

*4

TU-11 ←— VC-11 ←— C-11

1544 kbit/s

# FIG 2

10    11
S○   RT○ 8kHz

12 →

10
S○

3  1  8
PST ○—| -1 |—○  9
2 ○——| +1 |—○ 7
4 ○——| -1 |—○ 6
NST ○—| +1 |—
5

RT○ 8kHz
11

15
14
16

18
x
19
y

20
ZT○ 72kHz

17

22
z

21

24
U

25
ET○ 38,88 MHz

23
m:1
n:1

AT
→○ 26
2,048 MHz
(1,544 MHz)

13 →

S○   RT○ 8kHz
10    11

8

## FIG 3a

## FIG 3b

| | | | | | | | | | |
|---|---|---|---|---|---|---|---|---|---|
| 0 | 0 | 0 | 0 | | 0 | 0 | 0 | | 0 |
| 0 | 0 | 0 | 1 | | 1 | 1 | 1 | | −1 |
| 0 | 0 | 1 | 0 | | 0 | 0 | 1 | | +1 |
| 0 | 0 | 1 | 1 | | 0 | 0 | 0 | | 0 |
| 0 | 1 | 0 | 0 | | 1 | 1 | 1 | | −1 |
| 0 | 1 | 0 | 1 | | 1 | 1 | 0 | | −2 |
| 1 | 0 | 0 | 0 | | 0 | 0 | 1 | | +1 |
| 1 | 0 | 1 | 0 | | 0 | 1 | 0 | | +2 |
| 1 | 1 | 0 | 0 | | 0 | 0 | 0 | | 0 |

# FIG 4a

9, 9a,9b

# FIG 4b

| | PST | PST | PST | RPST | RPST | RPST | NST | NST | NST | RNST | RNST | RNST | |
|---|---|---|---|---|---|---|---|---|---|---|---|---|---|
| 8 | 0 o o o 0 | 0 | 1 | 1 | 1 | 1 | 1 | 1 | 0 | 0 | 0 | VZ |
| 7 | 0 o o o 0 | 0 | 1 | 1 | 1 | 1 | 1 | 1 | 0 | 0 | 0 | $2^1$ |
| 6 | 1 o o o 1 | 1 | 1 | 1 | 1 | 1 | 1 | 1 | 1 | 1 | 1 | $2^0$ |
| | +1 | +1 | +1 | −1 | −1 | −1 | −1 | −1 | −1 | +1 | +1 | +1 | |

| | PST | PST | PST | RPST | RPST | RPST | NST | NST | NST | RNST | RNST | RNST | |
|---|---|---|---|---|---|---|---|---|---|---|---|---|---|
| 47 | 0 o o o 0 | 0 | 0 | 0 | 0 | 1 | 1 | 1 | 1 | 1 | 0 | $2^2$ |
| 46 | 0 o o o 1 | 1 | 1 | 0 | 0 | 1 | 1 | 0 | 1 | 1 | 0 | $2^1$ |
| 45 | 1 o o o 0 | 1 | 0 | 1 | 0 | 1 | 0 | 1 | 0 | 1 | 0 | $2^0$ |
| | +1 | +2 | +3 | +2 | +1 | 0 | −1 | −2 | −3 | −2 | −1 | 0 | |

FIG 5

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 559 613 (MURPHY et al.)<br>* Figuren 1-5; Spalte 2, Zeile 9 - Seite 6, Zeile 33 *<br>--- | 1,8 | H 03 K 23/68<br>H 03 K 23/66 |
| A | EP-A-0 373 768 (NCR CORP.)<br>----- | | |

RECHERCHIERTE
SACHGEBIETE (Int. Cl.5)

H 03 K

Der vorliegende Recherchenbericht wurde für alle Patentansprüche erstellt

| Recherchenort | Abschlußdatum der Recherche | Prüfer |
|---|---|---|
| DEN HAAG | 08-08-1991 | FEUER F.S. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
...........................................................................
& : Mitglied der gleichen Patentfamilie, übereinstimmendes
    Dokument

EPO FORM 1503 03.82 (P0403)